# EUROPEAN PATENT SPECIFICATION

(11) **EP 4 571 341 B1**
(45) Date of publication and mention of the grant of the patent: **27.05.2026**
(21) Application number: 23307193.5
(22) Date of filing: 13.12.2023
(51) Int. Cl.: G01R 31/392, H01M 10/42

(54) **PROCESS OF MANAGING AN ELECTROCHEMICAL BATTERY AND SYSTEM FOR MANAGING AN ELECTROCHEMICAL BATTERY**
VERFAHREN ZUR VERWALTUNG EINER ELEKTROCHEMISCHEN BATTERIE UND SYSTEM ZUR VERWALTUNG EINER ELEKTROCHEMISCHEN BATTERIE
PROCÉDÉ DE GESTION D'UNE BATTERIE ÉLECTROCHIMIQUE ET SYSTÈME DE GESTION D'UNE BATTERIE ÉLECTROCHIMIQUE

(43) Date of publication of application: 18.06.2025
(73) Proprietor: Automotive Cells Company SE, 33520 Bruges (FR); Commissariat à l'Energie Atomique et aux Energies Alternatives, 75015 Paris (FR)
(72) Inventor: DESPREZ, Philippe, 33200 BORDEAUX (FR); BOUVET, Justin, 38054 GRENOBLE CEDEX 09 (FR); WOILLEZ, Eric, 38054 GRENOBLE CEDEX 09 (FR); CHANDESRIS, Marion, 38054 GRENOBLE CEDEX 09 (FR)
(74) Representative: Lavoix

(56) References cited:
- US-A- 4 743 855
- US-A1- 2016 131 719

## Description

The present invention relates to a process of managing an electrochemical battery by means of a battery management system, as well as to a battery management system for implementing this method and to a computer program comprising instructions which lead the battery management system to carry out the steps of the method.

In the field of electrochemical batteries, battery performances, particularly in terms of capacity, decrease irreversibly over time. The service life of an electrochemical battery is therefore limited.

There are many causes of electrochemical battery ageing. Cycling, i.e. the use of the battery during charging and/or discharging, is responsible for "cyclic" ageing, while storage of the battery at rest is responsible for "calendar" ageing.

We also know that "fast" battery charging, i.e. charging at high current levels, can cause accelerated ageing of electrochemical batteries.

Usually, an electrochemical battery is controlled by a Battery Management System (BMS) configured to optimize battery life by regulating the charging and discharging of the various electrochemical modules that make up the battery.

In particular, the battery management system incorporates means for assessing the State Of Charge (SOC) and the State Of Health (SOH) of the battery, the latter being representative of battery ageing.

Various methods of assessing the SOH of a battery are known.

Patent application US 2016/131719 discloses a battery management system configured to measure a first internal impedance of the battery at a first frequency in a first frequency range and a second internal impedance of the battery at a second frequency in a second frequency range, and to compare distances in the complex plane between a point corresponding to the first internal impedance and an origin of the complex plane, and between a point corresponding to the second internal impedance and the origin of the complex plane.

Patent application JP2022069223 describes a device for assessing the SOH of a battery, configured to determine an estimated value of the internal resistance of the battery at a given date on the basis of a voltage measurement and of a current intensity measurement at this date, and a model equation taking into account, among other things, a reference value of the internal resistance, a number of charge and discharge cycles and a storage duration. The SOH of the battery is then assessed by comparing the estimated internal resistance value with a predetermined value, in order to decide whether to disqualify the battery.

However, the model equation of JP2022069223 focuses only on cycling ageing and calendar ageing, and the weights assigned to the various terms to account for respectively cycling ageing and calendar ageing are fixed *a priori* such that they may not be suitable for modelling actual battery ageing, the causes of which are known to be multiple and complex.

One aim of the invention is therefore to propose a process of managing an electrochemical battery that enables the optimization of the operation of the battery in a more efficient manner, and in particular, that enables to further extend the battery's service life.

To this end, the object of the invention is a process for managing an electrochemical battery management system, the process comprising:
a) measuring at least one first internal resistance of the battery at at least a first frequency within a first frequency range and comparing the measured first internal resistance with a first reference internal resistance;
b1) if the first measured internal resistance is less than or equal to the first reference internal resistance, making a decision regarding continued use of the battery; and otherwise
b2) measuring at least one second internal resistance of the battery at at least one second frequency in a second frequency range lower than the first frequency range, and comparing a difference between the measured second internal resistance and the measured first internal resistance with a reference difference between a second reference internal resistance and the first reference internal resistance ; and
c1) if the difference is greater than or equal to the reference difference, making a decision regarding a disqualification of the battery ; and otherwise
c2) reducing an intensity of a fast charge and/or regeneration current for a subsequent charging step of the battery compared to an intensity of this charging current chosen before the measurement of the first internal resistance.

For at least part of the ageing cases, observing whether the first measured internal resistance at the first frequency is less than or equal to the first reference internal resistance makes it possible to discriminate between predominant cycling ageing, which is not associated with an increase of the first measured internal resistance, and other predominant types of ageing associated with an increase of the first measured internal resistance.

In the second alternative, measuring at least one second internal resistance of the battery at the at least one second frequency in a second frequency range lower than the first frequency range, and comparing the difference between the measured second internal resistance and the measured first internal resistance with the reference difference allows to further discriminate between calendar ageing, for which the difference D(t) is greater than or equal to the reference difference, and other types of ageing for which the difference D(t) is smaller than or equal to the reference difference.

In the last case, the ageing can be linked to a too high fast charge and/or regeneration current of the battery.

Consequently, this current can be subsequently reduced in order to limit premature ageing of the battery due the suboptimal charging management with respect to ageing, and hence to extend the battery's service.

According to other advantageous aspects of the invention, the method of managing an electrochemical battery comprises one or more of the following features, taken in isolation or in any technically possible combination:
- the first frequency range is comprised in the interval [500 Hz, 100 kHz];
- the second frequency range is comprised in the interval [0.01 Hz; 50 Hz];
- if continued use of the battery is decided at c1), the intensity of a fast charge and/or regeneration current is increased, advantageously incrementally;
- the making of a decision regarding disqualification of the battery comprises:
   c1i) providing an updated value of the second reference internal resistance with a processor of the battery management system implementing a calendar ageing model and receiving as input tuples, each representative of a state of charge of the battery at a given date, for at least two different dates prior to a date on which the process is implemented; then
   c1ii) comparing the difference between the measured second internal resistance and the measured first internal resistance with an updated difference between the updated value of second reference internal resistance and the first reference internal resistance and
   if the difference is greater than or equal to the updated reference difference, making a decision whether to keep the battery in operation; and if not
   c2) deciding not to disqualify the battery and to reduce the intensity of a fast charge and/or regeneration current;
- the measurement of the first internal resistance and the measurement of the second internal resistance are performed simultaneously;
- the steps of the process are periodically repeated;
- the reduction of the intensity of a fast charge and/or a regeneration courant is performed incrementally, preferably in a percentage of 5%;
- if a decision to increase the intensity has been made and a step of charging the battery with the increased intensity has been performed, for a first iteration of the process performed after the charging step, only step b2) and optionally c1) and c2) are performed.

The invention also relates to a management system for an electrochemical battery comprising means adapted to carry out the steps of the process according to any of the preceding embodiments.

Finally, the invention relates to a computer program comprising instructions, which cause the electrochemical battery management system to execute the process steps according to any of the preceding embodiments.

The invention will appear more clearly on reading the following description, given only as a non-limiting example, and made with reference to the drawings in which:
- figure 1 is an exploded view of an electrochemical battery;
- figure 2 is a flow chart of the process according to the invention;
- figure 3 is a detailed flow chart of the making of a decision whether to disqualify the battery according to one embodiment;
- figure 4 represents the internal resistance of a given battery 10 at a given date t as a function of the frequency at which the internal resistance is measured, the frequency being represented with a logarithmic scale, the resistance being measured at a temperature of 45°C for exemplary batteries A to H; and
- figure 5 represents the internal resistance of a given battery 10 at a given date t as a function of the frequency at which the internal resistance is measured, the frequency being represented with a logarithmic scale, the resistance being measured at a temperature of 25°C for exemplary batteries A, B and E to H.

The process of managing an electrochemical battery 10 is intended to be carried out by a battery management system (hereafter designed as BMS) 15 integrated in the electrochemical battery 10.

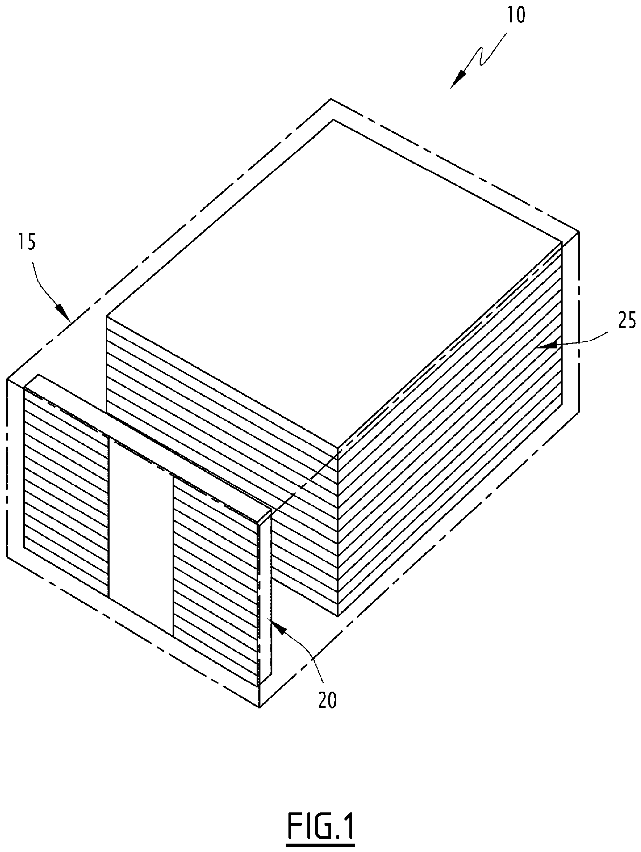

A typical electrochemical battery 10 is represented on figure 1.

The battery 10 is for example a Lithium-ion (Li-ion) battery.

The battery 10 is for example adapted for use in a battery electric vehicle (not represented).

The battery 10 comprises a housing 20 in which a plurality of electrochemical cells 25 are stacked and each connected to the BMS 15,
The BMS 15 is configured to manage the performance and operation of the battery 10.

By way of non-limitative examples, the BMS 15 is configured to protect the battery 10 from operating outside a predetermined working temperature range, and/or for monitoring the state of charge (SOC) of the battery 10, and/or for calculating and/or reporting data to other control systems of an apparatus powered by the battery 10.

The BMS 15 is also configured to control recharging of the battery 10.

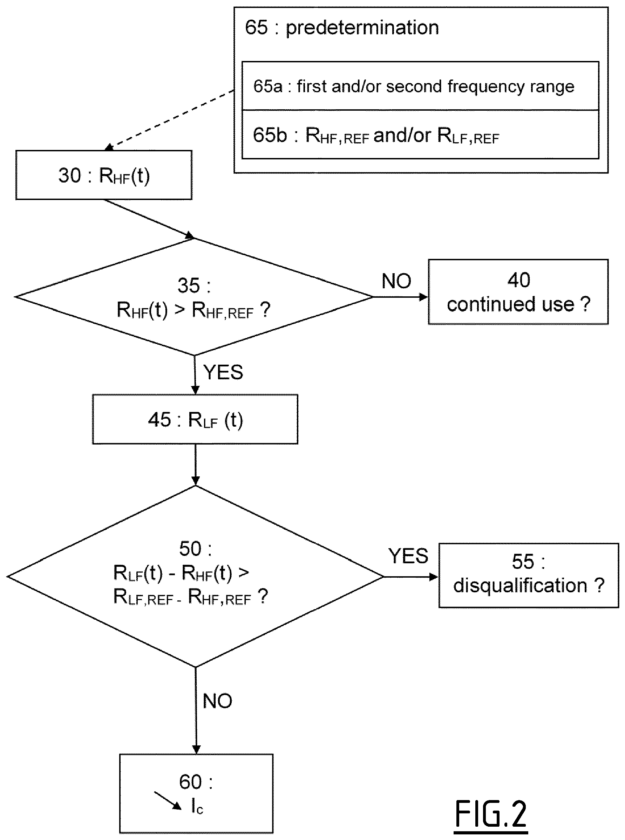

In reference to figure 2, a process of managing the battery 10 with the BMS 15 according to the invention is described hereafter.

The process comprises a first measurement step 30 at which at least one first internal resistance R_{HF}(t) of the battery 10 at a given date t at a first frequency f₁ within a first frequency range is measured with impedance measurement means of the BMS 15.

Typically, the first frequency range is comprised in the interval [500 Hz, 100 kHz], preferably [500 Hz, 50 kHz], more preferably [500 Hz, 20 kHz].

Advantageously, the first frequency range is [1 kHz, 10 kHz]

Preferably, the first frequency f₁ is of the order of 1 kHz to 10 kHz.

The measurement of the first internal resistance R_{HF}(t) of the battery 10 comprises the measurement of at least one internal resistance of the battery at the given date t at the first frequency f₁.

Preferably, the measurement of the first internal resistance R_{HF}(t) of the battery 10 is performed at a first temperature θ1(t).

The first temperature θ1(t) is advantageously comprised between 15°C and 60°C, more preferably between 20°C and 50°C, even more preferably between 25°C and 45°C.

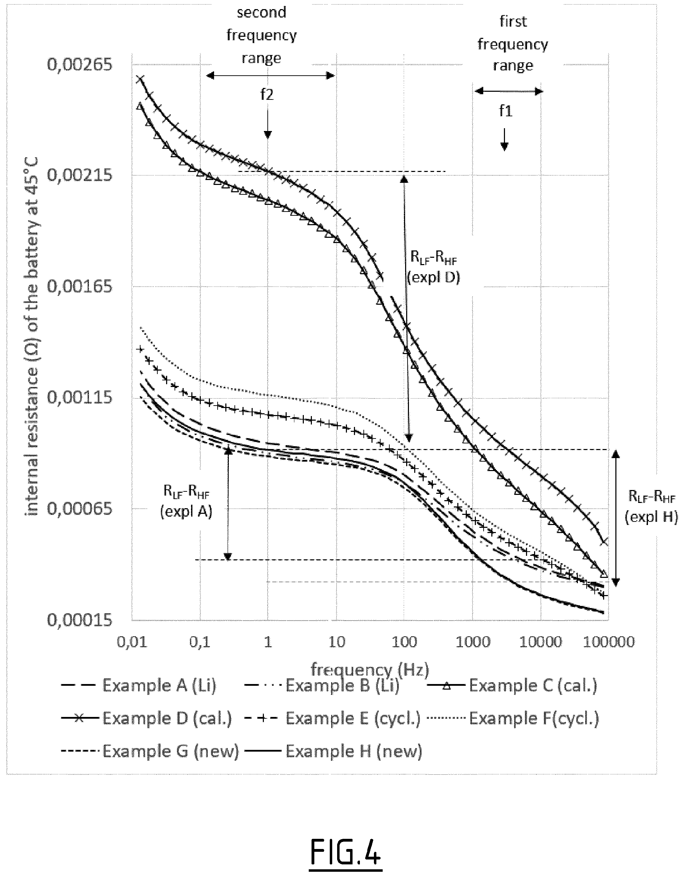

As can be seen on figure 4, the inventors have observed that whatever the state of health, the internal resistance of a Li-ion battery 10 varies very slowly with the frequency in a low frequency range (typically [0,1 Hz, 10 Hz] for the batteries of figure 4), as well as in a high frequency range (typically [1 kHz, 10 kHz] for the batteries of figure 4), whereas it varies much faster with the frequency in a medium frequency range (typically [10 Hz, 1 kHz] for the batteries of figure 4). Consequently, the particular value of the first frequency f₁ chosen within the first frequency range, being in the case of figure 4 the high frequency range, is of little importance for the rest of process in the case of Li-ion battery.

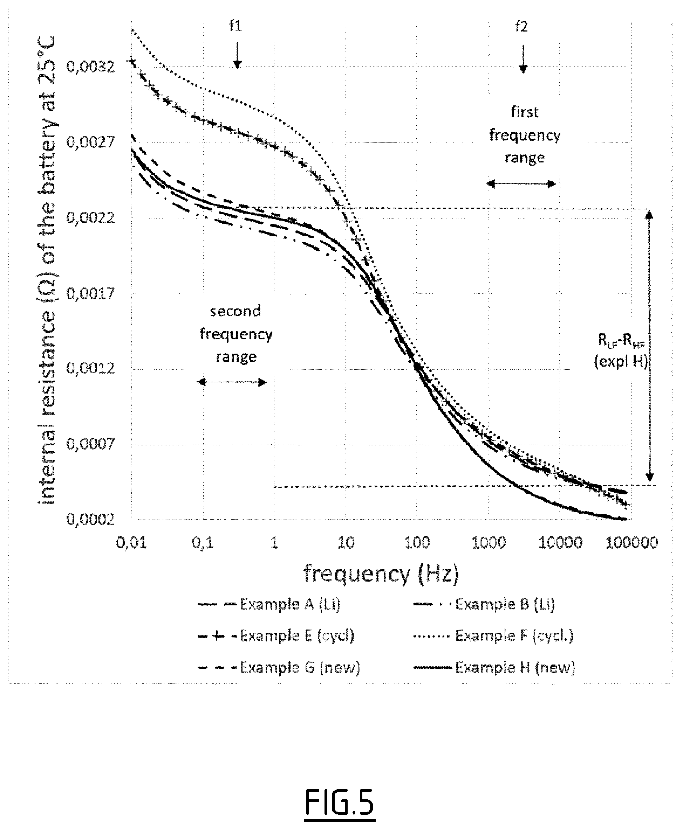

This appears even more clearly on figure 5, for which the measurements have been performed at a temperature of 25°C.

Optionally, in order to take into account the low variations of the internal resistance within the first frequency range, for example for other type of batteries 10, a plurality of internal resistances of the battery at a plurality of first frequencies within the first frequency range and/or at a plurality of dates t within a predetermined measurement period T are performed.

In this case, the first internal resistance R_{HF}(t) measured at step 30 is a mean value of the plurality of internal resistances measured.

Then, the process comprises a first comparison step 35 of the first internal resistance R_{HF}(t) measured with a first reference internal resistance R_{HF,REF}.

The first comparison 35 is performed with a processor of the BMS 15.

The first reference internal resistance R_{HF},_{REF} is a measured or expected internal resistance of the battery 10 at the first frequency f₁ before any use of the battery 10.

In other words, the first reference internal resistance R_{HF},_{REF} is a predetermined value representative of the internal resistance of the battery 10 within the first frequency range, preferably at the first frequency f₁, before ageing.

The first reference internal resistance R_{HF},_{REF} is preferably representative of the internal resistance of the battery 10 within the first frequency range, preferably at the first frequency f₁, before ageing, preferably at the temperature θ1(t) of the battery 10 at which the first internal resistance R_{HF}(t) has been measured.

If the first internal resistance R_{HF}(t) measured is considered as strictly higher than the first reference internal resistance R_{HF},_{REF}, or equivalently if the difference between the ratio of the difference between first internal resistance R_{HF}(t) and the first reference internal resistance R_{HF},_{REF} and of the first reference internal resistance R_{HF},_{REF} is higher than a first predetermined tolerance value TOL, the process comprises a decision step 40 regarding whether to continue to use the battery 10 or not. Otherwise, the process comprises a second measurement step 45.

The TOL value is advantageously of less than 5%, preferably less than 2%, more preferably less than 1%.

For example, the decision step 40 comprises deciding to operate the battery without changes.

Optionally, if a continued use of the battery in the apparatus is decided, a fast charge and/or regeneration current intensity I_{c} of the battery 10 for a subsequent charging step of the battery 10, compared to an intensity of this charging current chosen before the measurement of the first internal resistance R_{HF}(t), is increased, advantageously incrementally.

Indeed, the fact that the process results in step 40 allows considering that the fast charge and/or regeneration current intensity I_{c} implemented by the BMS 15 prior to the process is not too high, as will be explained later.

At the second measurement step 45, a second internal resistance R_{LF}(t) of the battery 10 at the given date t at a second frequency f₂ within a second frequency range is measured with impedance measurement means of the BMS 15.

An upper frequency of the second frequency range is lower than a lower frequency of the first frequency range, such that the second frequency f₂ is necessarily lower than the first frequency f₁.

Typically, the second frequency range is comprised in the interval [0.01 Hz, 50 Hz], preferably [0.05 Hz, 20 Hz], more preferably [0.07 Hz, 20 Hz].

Advantageously, the second frequency range is [0.1 Hz, 10 Hz]

Preferably, the second frequency f₂ is of the order of 0.1 Hz to 1 Hz.

The measurement of the second internal resistance R_{LF}(t) of the battery 10 comprises the measurement of at least one internal resistance of the battery at the given date t at the second frequency f₂.

Preferably, the measurement of the second internal resistance R_{LF}(t) of the battery 10 is performed at a second temperature θ2(t).

The second temperature θ2(t) is advantageously comprised between 15°C and 60°C, more preferably between 20°C and 50°C, even more preferably between 25°C and 45°C.

The second temperature θ2(t) is advantageously equal to the first temperature θ1(t).

As already explained and shown on figure 4, the inventors have observed that whatever the state of health, the internal resistance of a Li-ion battery 10 varies very slowly with the frequency in the low frequency range (typically [0,1 Hz, 10 Hz] for the batteries of figure 4).

Consequently, the particular value of the second frequency f₂ chosen within the second frequency range, being in the case of figure 4 the low frequency range, is of little importance for the rest of process in the case of Li-ion battery.

Optionally, in order to take into account the low variations of the internal resistance within the second frequency range, for example for other type of batteries 10, a plurality of internal resistances of the battery at a plurality of second frequencies within the second frequency range and/or at a plurality of dates t within the predetermined measurement period T are performed.

In this case, the second internal resistance R_{LF}(t) measured at step 45 is a mean value of the plurality of internal resistances measured.

Optionally, the first measurement step 30 and the second measurement step 45 are performed simultaneously.

Then, the process comprises a second comparison step 50 of a difference D(t) = R_{LF}(t) - R_{HF}(t) between the measured second internal resistance R_{LF}(t) and the measured first internal resistance R_{HF}(t), with a reference difference D_{REF} = R_{LF},_{REF} - R_{HF},_{REF} between a second reference internal resistance R_{LF},_{REF} and the first reference internal resistance R_{HF},_{REF}.

The second comparison 50 is performed with the processor of the BMS 15.

The first reference internal resistance R_{HF},_{REF} is a measured or expected internal resistance of the battery 10 at the first frequency f₁ before any use of the battery 10.

In other words, the first reference internal resistance R_{HF},_{REF} is a predetermined value representative of the internal resistance of the battery 10 within the first frequency range, preferably at the first frequency f₁, before ageing.

The second reference internal resistance R_{LF},_{REF} is preferably representative of the internal resistance of the battery 10 within the second frequency range, preferably at the second frequency f₂, before ageing, preferably at the temperature θ2(t) of the battery 10 at which the second internal resistance R_{LF}(t) has been measured.

If the difference D(t) is considered as strictly higher than the reference difference D_{REF}, or equivalently if the difference between the ratio of the difference between D(t) and D_{REF} and of D_{REF} is higher than a second predetermined tolerance value TOL2, the process comprises a decision step 55 regarding whether to disqualify the battery 10 or not. Otherwise, the process comprises a reduction step 60.

As can be seen on figure 4, the difference D(t) is higher than the reference difference D_{REF} measured for the new battery (examples G and H) in case a subsequent ageing is performed by either purely calendar ageing (examples C and D) or purely cycling ageing (examples E and F).

On the contrary, the difference D(t) is lower than the reference difference D_{REF} measured for the new battery (examples G and H) in case a subsequent ageing is performed by Li-plating (examples A and B).

This appears even more clearly on figure 5, for which the measurements have been performed at a temperature of 25°C.

Hence, without wishing to be bound by any theory, the inventors are of the opinion that the comparison of the difference D(t) with the reference difference D_{REF} allows to discriminate between different types of ageing and in particular, to identify cases where the ageing is due to a too high charge current intensity.

In case of Li-ion battery, a too high charge current intensity induces in particular Li plating of the electrodes that can be observed macroscopically.

This example is given only for explanatory purposes, since many other physicochemical consequences of a high charge current intensity, either for Li-ion battery or for other type of battery, can lead to the reduction of the difference D(t) compared to the reference difference D_{REF}.

The reduction step 60 comprises reducing an intensity I_{c} of a charge current either for a subsequent charge or a subsequent regeneration of the battery 10, compared to the intensity implemented by the BMS 15 before the first measurement step 30.

The charge current can be a fast charge current, i.e., an electrical current supplied to the battery 10 for its fast charging with a charger.

Alternatively or in addition, the charge current is a regeneration current, i.e., an electrical current supplied to the battery 10 for its charging with a regenerative braking system of a battery electric vehicle, the vehicle being equipped with the battery 10.

The fast charge current and/or the regeneration current is for example a pulsed current. The pulse with is for example comprised between 1s to 10s, preferably 2s to 10s.

The reduction of the intensity I_{c} is for example incremental. In this case, each time the process is performed and results in a reduction step 60, the intensity I_{c} is decreased of a predetermined percentage.

By way of an example, the predetermined percentage is 5%.

This allows, in cases where the process according to the invention is iteratively performed, to progressively converge towards the optimal charge intensity I_{c} instead of a too drastic reduction.

Since the observed reduction of the difference D(t) is considered as a consequence of an ageing process which is linked to a too high charge current intensity, and which is neither calendar ageing nor cycling ageing, such a reduction allows to limit premature ageing of the battery 10 due to a charging management which is suboptimal with respect to ageing.

In some cases, this also prevents disqualification of the battery 10 due to lack of discrimination between the different types of ageing processes.

If the reduction step 60 is not performed, the decision step 55 regarding whether to disqualify the battery 10 or not is performed with the processor of the BMS 15.

The decision step 55 comprises making a decision whether to disqualify the battery 10 for equipping the apparatus or not.

For example, the decision step 55 comprises deciding to continue the operation of the battery 10 without changes.

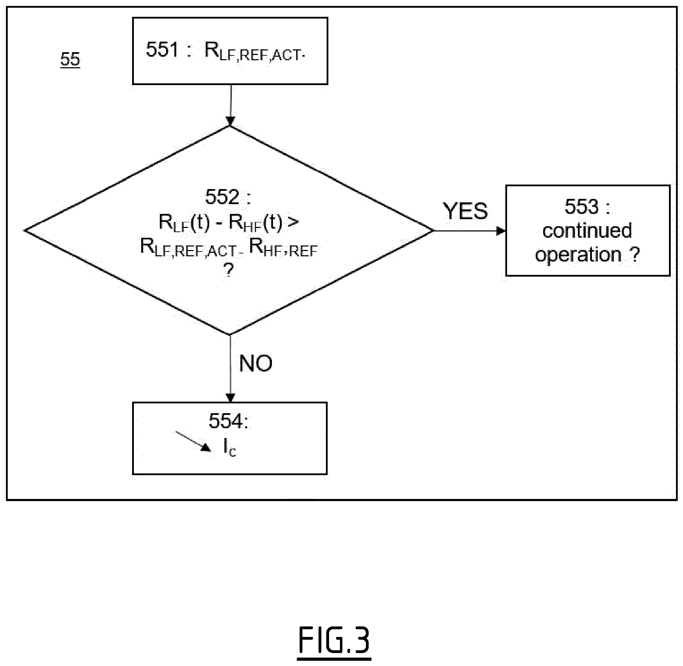

In an alternative embodiment represented on figure 3, the decision step 55 comprises an actualization step 551 at which the processor of the BMS 15 implementing a calendar ageing model calculates updated value R_{LF,REF,ACT} of the second reference internal resistance R_{LF,REF}.

For example, the processor receives a plurality of SOC-tuples from means for monitoring the state of charge SOC of the battery comprised in the BMS 15. Each tuple SOC-tuple comprises a battery charge level and a battery temperature measured with the monitoring means at a given date t'.

Preferably, the dates t' are evenly distributed between a beginning of the use of the battery 10 and the given date t at which the first measurement step 30 is performed.

Based on the tuples SOC-tuples, the processor of the BMS 15 can determine the time spent by the battery 10 at any level of charge comprises between 0% and 100% and any temperature comprised between a minimum temperature and a maximum temperature.

Thanks to the calendar ageing model receiving these data, the processor can thus determine the updated value R_{LF,REF,ACT}, which represents an expected second reference internal resistance if no calendar had occurred.

This is particularly advantageous since calendar ageing is associated with a significant increase in the difference D(t), which can hide a reduction of the difference D(t) due to a too high charge current intensity, even if the second measurement step 45 has been performed.

This can be understood by comparing example A and D on figure 4.

The decision step 55 then comprises a third comparison step 552, a second reduction step 554 and a decision step 553 whether to keep the battery 10 in operation to power the apparatus, which are analogous *mutatis mutandis* to respectively the second comparison step 50, the reduction step 60 and the decision step 55 whether to disqualify the battery 10 or not.

Optionally, the process comprises a preliminary step 65 of determination for determining one or more predetermined values implemented in the first measurement step 30 and/or in the second measurement step 45 and/or in the first comparison step 35 and/or in the second comparison step 50 and/or in the decision regarding disqualification step 55.

The preliminary step 65 may comprise a step 65a for determining the first frequency range and/or of the second frequency range for the battery 10.

For example, a reference battery representative of a type of electrochemical reaction occurring in the battery 10 and/or of an architecture of the battery 10 can be provided.

The internal resistance of the reference battery is then measured for a plurality of frequencies in the range [0 Hz, 100 kHz] at at least one predetermined temperature.

Finally, a first and a second frequency range within which the internal resistance of the reference battery varies much less than within a third frequency range comprised between the first frequency range and the second frequency range are determined, the frequencies in the first frequency range being higher than the frequencies in the second frequency range.

The preliminary step 65 can comprise a step 65b for determining the first reference internal resistance R_{HF},_{REF} and/or the second reference internal resistance R_{LF},_{REF}.

For example, the first reference internal resistance R_{HF},_{REF} of the battery 10 is measured at at least one predetermined temperature at the first frequency f₁ before any use of the battery 10.

As a variant, the first reference internal resistance R_{HF},_{REF} of the reference battery is measured at at least one predetermined temperature at the first frequency f₁ before any use of the reference battery.

Advantageously, the preliminary step 65 comprises both steps 65a and 65b.

One understands that the process according to the invention allows to discriminate between calendar and cycling ageing processes and other ageing processes, and as a consequence to adapt the intensity of the charge current of the battery in case other ageing processes are observe.

Consequently, the service life of the battery 10 is increased compared to prior art processes and some premature disqualifications can be prevented.

Optionally, the steps of the process are periodically repeated. Advantageously, the first temperature θ1(t) and/or the second temperature θ2(t) are chosen at each repetition of the process according to the current use of the battery 10.

### Examples

The experiments of examples A to H were performed on identical Li-ion batteries comprising:
a) an anode comprising :
   - 97% by weight of a blend of natural and synthetic graphite;
   - 1,5% by weight of a carboxymethyl cellulose (CMC) binder; and
   - 1,5% by weight of a styrene-butadiene rubber (SBR) binder;
   the anode having a porosity of 26% and an active material load of 15 mg/cm²;
b) a cathode of the NMC 811 type (Nickel 80 at% - Manganèse 10 at% - Cobalt 10 at%);
c) a polyolefine based separator coated with Aluminum;
d) an electrolyte comprising a LiPF₆ salt dissolved in a ternary solvent mixture of ethylene carbonate (EC), dimethyl carbonate (DMC), diethyl carbonate (DEC) and ethyl methyl carbonate (EMC).

The fast-charge ageing protocol used for examples A and B is designed to promote lithium metal deposition on the anode. The fast-charge ageing protocol comprises the following steps, performed in a climatic chamber at 25°C:
a) perform a capacity control cycle ;
b) have the battery rest for 10 min;
c) charge the battery at a 1C rate until the battery voltage is equal to 4,2V and then float charge for 2 h at a charge rate of less than C/20;
d) have the battery rest for 10 min;
e) discharge the battery at a C/5 rate until the battery voltage is equal to 2,7V;
f) have the battery rest for 10 min; and
g) perform a capacity control cycle.

The calendar storage ageing protocol used for examples C and D is designed to promote solid electrolyte interface (SEI) growth and cathode degradation. The calendar storage ageing protocol comprises the following steps, performed in a climatic chamber at 60°C:
a) discharge the battery at 25°C in a climatic chamber at a C/10 rate until the battery voltage is equal to 2,7V;
b) perform a capacity control cycle at 25°C in a climatic chamber;
c) charge the battery at a C/10 rate until the battery voltage is equal to 4,2V and then float charge for 2 h at a charge rate of less than C/20 at 25°C in a climatic chamber;
d) store the battery during 15 days in a climatic chamber at 60°C at 100% State of Charge (SOC) measured with the open circuit voltage (OCV) method.

The cycling ageing protocol used for examples E and F is designed to promote promote ageing mechanisms associated with the full lithiation of delithiation of the different active materials. The cycling ageing protocol comprises the following steps, performed in a climatic chamber at 45°C:
a) perform a capacity control cycle ;
b) perform a resistance control cycle
c) have the battery rest for 10 min;
d) charge the battery at a C/3 rate until the battery voltage is equal to 4,2V and then float charge for 2 h at a charge rate of less than C/20;
e) have the battery rest for 10 min;
f) discharge the battery at a C/5 rate until the battery voltage is equal to 2,7V;
g) have the battery rest for 10 min; and
h) return to step d) for 50 cycles comprising d) to h) then go to step a) until a total of 500 cycles comprising d) to h).

## Claims

1. A process of managing an electrochemical battery (10) by means of a battery management system (15), the process comprising:
(a) measuring at least one first internal resistance (R_{HF}(t)) of the battery at at least a first frequency (f₁) within a first frequency range and comparing the measured first internal resistance (R_{HF}(t)) with a first reference internal resistance (R_{HF},_{REF});
(b1) if the first measured internal resistance (R_{HF}(t)) is less than or equal to the first reference internal resistance (R_{HF},_{REF}), making a decision regarding continued use of the battery (10); and otherwise
(b2) measuring at least one second internal resistance (R_{LF}(t)) of the battery at at least one second frequency (f₂) in a second frequency range lower than the first frequency range, and comparing a difference D(t) between the measured second internal resistance (R_{LF}(t)) and the measured first internal resistance (R_{HF}(t)) with a reference difference (D_{REF}) between a second reference internal resistance (R_{LF},_{REF}) and the first reference internal resistance (R_{HF},_{REF}); and
(c1) if the difference D(t) is greater than or equal to the reference difference (D_{REF}), making a decision regarding a disqualification of the battery (10); and otherwise
(c2) reducing an intensity (I_{c}) of a fast charge and/or regeneration current for a subsequent charging step of the battery (10) compared to an intensity of this charging current chosen before the measurement of the first internal resistance (R_{HF}(t)).

2. Process of managing an electrochemical battery (10) according to claim 1, wherein the first frequency range is comprised in the interval [500 Hz, 100 kHz].

3. Process of managing an electrochemical battery (10) according to claim 2, wherein the second frequency range is comprised in the interval [0.01 Hz; 50 Hz].

4. Process of managing an electrochemical battery (10) according to claim 1, wherein if continued use of the battery (10) is decided at c1), the intensity (I_{c}) of a fast charge and/or regeneration current is increased, advantageously incrementally.

5. Process of managing an electrochemical battery (10) according to any of the preceding claims, wherein the making of a decision regarding disqualification of the battery (10) comprises:
(c1i) providing an updated value of the second reference internal resistance (R_{LF,REF,ACT}) with a processor of the battery management system (15) implementing a calendar ageing model and receiving as input tuples (SOC-tuple), each representative of a state of charge (SOC) of the battery (10) at a given date, for at least two different dates prior to a date (t) on which the process is implemented; then
(c1ii) comparing the difference D(t) between the measured second internal resistance (R_{LF}(t)) and the measured first internal resistance (R_{HF}(t)) with an updated difference (D_{ACT}(t)) between the updated value of second reference internal resistance (R_{LF,REF,ACT}) and the first reference internal resistance (R_{HF,REF}); and
(c1ii) if the difference D(t) is greater than or equal to the updated reference difference, making a decision whether to keep the battery in operation; and if not
(c2) deciding not to disqualify the battery (10) and to reduce the intensity (I_{c}) of a fast charge and/or regeneration current.

6. Process of managing an electrochemical battery (10) according to any of the preceding claims, wherein the measurement of the first internal resistance (R_{HF}(t)) and the measurement of the second internal resistance (R_{LF}(t)) are performed simultaneously.

7. Process of managing an electrochemical battery (10) according to any of the preceding claims, wherein the steps of the process are periodically repeated.

8. Process of managing an electrochemical battery (10) according to claim 7, wherein the reduction of the intensity (I_{c}) of a fast charge and/or a regeneration courant is performed incrementally, preferably in a percentage of 5%.

9. Process of managing an electrochemical battery (10) according to any of claims 7 and 8, wherein if a decision to increase the intensity (I_{c}) has been made and a step of charging the battery (10) with the increased intensity (I_{c}) has been performed, for a first iteration of the process performed after the charging step, only step (b2) and optionally (c1) and (c2) are performed.

10. An electrochemical battery management system (15) comprising means adapted to perform the steps of the process according to any of the preceding claims.

11. A computer program comprising instructions which cause an electrochemical battery management system (15) according to claim 10 to perform the process steps of any of claims 1 to 9.

## Patentansprüche

1. Verfahren zur Verwaltung einer elektrochemischen Batterie (10) mittels eines Batterieverwaltungssystems (15), das Verfahren umfassend:
(a) Messen mindestens eines ersten Innenwiderstands (R_{HF}(t)) der Batterie bei mindestens einer ersten Frequenz (f₁) innerhalb eines ersten Frequenzbereichs und Vergleichen des gemessenen ersten Innenwiderstands (R_{HF}(t)) mit einem ersten Referenzinnenwiderstand (R_{HF,} R_{EF});
(b1) wenn der erste gemessene Innenwiderstand (R_{HF}(t)) kleiner oder gleich der erste Referenzinnenwiderstand (R_{HF,} R_{EF}) ist, Treffen einer Entscheidung über die weitere Verwendung der Batterie (10); und andernfalls
(b2) Messen mindestens eines zweiten Innenwiderstands (R_{LF}(t)) der Batterie bei mindestens einer zweiten Frequenz (f₂) in einem zweiten Frequenzbereich, der niedriger ist als der erste Frequenzbereich, und Vergleichen einer Differenz D(t) zwischen dem gemessenen zweiten Innenwiderstand (R_{LF}(t)) und dem gemessenen ersten Innenwiderstand (R_{HF}(t)) mit einer Referenzdifferenz (D_{REF}) zwischen einem zweiten Referenzinnenwiderstand (R_{LF,} R_{EF}) und dem ersten Referenzinnenwiderstand (R_{HF,} R_{EF}); und
(c1) wenn die Differenz D(t) größer oder gleich der Referenzdifferenz (D_{REF}) ist, Treffen einer Entscheidung über eine Disqualifikation der Batterie (10); und andernfalls
(c2) Reduzieren einer Stromstärke (I_{c}) eines Schnelllade- und/oder Regenerationsstroms für einen nachfolgenden Ladeschritt der Batterie (10) im Vergleich zu einer vor der Messung des ersten Innenwiderstands (R_{HF}(t)) gewählten Intensität dieses Ladestroms.

2. Verfahren zur Verwaltung einer elektrochemischen Batterie (10) nach Anspruch 1, wobei der erste Frequenzbereich im Intervall [500 Hz, 100 kHz] liegt.

3. Verfahren zur Verwaltung einer elektrochemischen Batterie (10) nach Anspruch 2, wobei der zweite Frequenzbereich im Intervall [0,01 Hz; 50 Hz] liegt.

4. Verfahren zur Verwaltung einer elektrochemischen Batterie (10) nach Anspruch 1, wobei, wenn bei c1) über die weitere Verwendung der Batterie (10) entschieden wird, die Stromstärke (I_{c}) eines Schnelllade- und/oder Regenerationsstroms vorteilhafterweise inkrementell erhöht wird.

5. Verfahren zur Verwaltung einer elektrochemischen Batterie (10) nach einem der vorherigen Ansprüche, wobei das Treffen einer Entscheidung in Bezug auf eine Disqualifikation der Batterie (10) Folgendes umfasst:
(c1i) Bereitstellen eines aktualisierten Werts des zweiten Referenzinnenwiderstands (R_{LF,} R_{EF,} A_{CT}) mit einem Prozessor des Batterieverwaltungssystems (15), der ein Kalender-Alterungsmodell implementiert, und Empfangen von Tupeln (SOC-Tupel) als Eingang, die jeweils repräsentativ für einen Ladezustand (SOC) der Batterie (10) zu einem gegebenen Datum sind, für mindestens zwei verschiedene Daten vor einem Datum (t), an dem das Verfahren implementiert wird; dann
(c1ii) Vergleichen der Differenz D(t) zwischen dem gemessenen zweiten Innenwiderstand (R_{LF}(t)) und dem gemessenen ersten Innenwiderstand (R_{HF}(t)) mit einer aktualisierten Differenz (D_{ACT}(t)) zwischen dem aktualisierten Wert des zweiten Referenzinnenwiderstands (R_{LF,} R_{EF,} A_{CT}) und dem ersten Referenzinnenwiderstand (R_{HF,} R_{EF}); und
(c1ii) wenn die Differenz D(t) größer oder gleich der aktualisierten Referenzdifferenz ist, Treffen einer Entscheidung, ob die Batterie in Betrieb bleiben soll; und wenn nicht
(c2) Entscheiden, die Batterie (10) nicht zu disqualifizieren und die Stromstärke (I_{c}) eines Schnelllade- und/oder Regenerationsstroms zu reduzieren.

6. Verfahren zur Verwaltung einer elektrochemischen Batterie (10) nach einem der vorherigen Ansprüche, wobei die Messung des ersten Innenwiderstands (R_{HF}(t)) und die Messung des zweiten Innenwiderstands (R_{LF}(t)) gleichzeitig durchgeführt werden.

7. Verfahren zur Verwaltung einer elektrochemischen Batterie (10) nach einem der vorherigen Ansprüche, wobei die Schritte des Verfahrens periodisch wiederholt werden.

8. Verfahren zur Verwaltung einer elektrochemischen Batterie (10) nach Anspruch 7, wobei die Verringerung der Stromstärke (I_{c}) eines Schnelllade- und/oder Regenerationsstroms inkrementell, vorzugsweise in einem Prozentsatz von 5 %, durchgeführt wird.

9. Verfahren zur Verwaltung einer elektrochemischen Batterie (10) nach einem der Ansprüche 7 und 8, wobei, wenn eine Entscheidung zur Erhöhung der Stromstärke (I_{c}) getroffen wurde und ein Schritt zum Laden der Batterie (10) mit der erhöhten Stromstärke (I_{c}) durchgeführt wurde, für eine erste Iteration des Verfahrens, die nach dem Ladeschritt durchgeführt wird, nur der Schritt (b2) und optional (c1) und (c2) durchgeführt werden.

10. Elektrochemisches Batterieverwaltungssystem (15), umfassend Einrichtungen, die angepasst sind, um die Schritte des Verfahrens nach einem der vorherigen Ansprüche durchzuführen.

11. Computerprogramm mit Anweisungen, die ein elektrochemisches Batterieverwaltungssystem (15) nach Anspruch 10 veranlassen, die Verfahrensschritte nach einem der Ansprüche 1 bis 9 durchzuführen.

## Revendications

1. Procédé de gestion d'une batterie électrochimique (10) au moyen d'un système de gestion de batterie (15), le procédé comprenant :
(a) la mesure d'au moins une première résistance interne (R_{HF}(t)) de la batterie à au moins une première fréquence (f₁) dans une première gamme de fréquences et la comparaison de la première résistance interne (R_{HF}(t)) mesurée à une première résistance interne de référence (R_{HF},_{REF}) ;
(b1) si la première résistance interne (R_{HF}(t)) mesurée est inférieure ou égale à la première résistance interne de référence (R_{HF,REF}), la prise d'une décision concernant la poursuite de l'utilisation de la batterie (10) ; et sinon
(b2) la mesure d'au moins une seconde résistance interne (R_{LF}(t)) de la batterie à au moins une seconde fréquence (f₂) dans une seconde gamme de fréquences inférieure à la première gamme de fréquences, et la comparaison d'une différence D(t) entre la seconde résistance interne (R_{LF}(t)) mesurée et la première résistance interne (R_{HF}(t)) mesurée avec une différence de référence (D_{REF}) entre une seconde résistance interne de référence (R_{LF,REF}) et la première résistance interne de référence (R_{HF,REF}) ; et
(c1) si la différence D(t) est supérieure ou égale à la différence de référence (D_{REF}), la prise d'une décision concernant un arrêt de l'utilisation de la batterie (10) ; et sinon
(c2) la réduction d'une intensité (I_{c}) d'un courant de charge rapide et/ou de régénération pour une étape de charge ultérieure de la batterie (10) par rapport à une intensité de ce courant de charge choisie avant la mesure de la première résistance interne (R_{HF}(t)).

2. Procédé de gestion d'une batterie électrochimique (10) selon la revendication 1, dans lequel la première gamme de fréquences est comprise dans l'intervalle [500 Hz, 100 kHz].

3. Procédé de gestion d'une batterie électrochimique (10) selon la revendication 2, dans lequel la seconde gamme de fréquences est comprise dans l'intervalle [0,01 Hz ; 50 Hz].

4. Procédé de gestion d'une batterie électrochimique (10) selon la revendication 1, dans lequel si la poursuite de l'utilisation de la batterie (10) est décidée en c1), l'intensité (I_{c}) d'un courant de charge rapide et/ou de régénération est augmentée, avantageusement par incréments.

5. Procédé de gestion d'une batterie électrochimique (10) selon l'une quelconque des revendications précédentes, dans lequel la prise de décision concernant l'arrêt de l'utilisation de la batterie (10) comprend :
(c1i) la fourniture d'une valeur actualisée de la seconde résistance interne de référence (R_{LF,REF,ACT}) à un processeur du système de gestion de batterie (15) mettant en œuvre un modèle de vieillissement calendaire et recevant en entrée des uplets (SOC-uplet), chacun représentatif d'un état de charge (SOC) de la batterie (10) à une date donnée, pour au moins deux dates différentes antérieures à une date (t) à laquelle le procédé est mis en œuvre ; puis
(c1ii) la comparaison de la différence D(t) entre la seconde résistance interne (R_{LF}(t)) mesurée et la première résistance interne (R_{HF}(t)) mesurée avec une différence actualisée (D_{ACT}(t)) entre la valeur actualisée de la seconde résistance interne de référence (R_{LF,REF,ACT}) et la première résistance interne de référence (R_{HF,REF}) ; et
(c1ii) si la différence D(t) est supérieure ou égale à la différence de référence actualisée, la prise d'une décision concernant le maintien ou non de la batterie en fonctionnement ; et dans le cas contraire
(c2) la décision de ne pas arrêter l'utilisation de la batterie (10) et de réduire l'intensité (I_{c}) d'un courant de charge rapide et/ou de régénération.

6. Procédé de gestion d'une batterie électrochimique (10) selon l'une quelconque des revendications précédentes, dans lequel la mesure de la première résistance interne (R_{HF}(t)) et la mesure de la seconde résistance interne (R_{LF}(t)) sont effectuées simultanément.

7. Procédé de gestion d'une batterie électrochimique (10) selon l'une quelconque des revendications précédentes, dans lequel les étapes du procédé sont répétées périodiquement.

8. Procédé de gestion d'une batterie électrochimique (10) selon la revendication 7, dans lequel la réduction de l'intensité (I_{c}) d'un courant de charge rapide et/ou d'un courant de régénération est réalisée par incréments, de préférence de 5 %.

9. Procédé de gestion d'une batterie électrochimique (10) selon l'une quelconque des revendications 7 et 8, dans lequel, si une décision d'augmenter l'intensité (I_{c}) a été prise et qu'une étape de charge de la batterie (10) avec l'intensité (I_{c}) augmentée a été réalisée, pour une première itération du procédé réalisée après l'étape de charge, seule l'étape (b2) et facultativement (c1) et (c2) sont réalisées.

10. Système de gestion de batterie électrochimique (15) comprenant des moyens adaptés pour réaliser les étapes du procédé selon l'une quelconque des revendications précédentes.

11. Programme informatique comprenant des instructions qui amènent un système de gestion de batterie électrochimique (15) selon la revendication 10 à exécuter les étapes du procédé selon l'une quelconque des revendications 1 à 9.
